Europäisches Patentamt

European Patent Office

Office européen des brevets

(19)

(11) Veröffentlichungsnummer: **0 492 118 A1**

## (12) EUROPÄISCHE PATENTANMELDUNG

(21) Anmeldenummer: **91119486.8**

(22) Anmeldetag: **15.11.91**

(51) Int. Cl.5: **G06F 11/26**

(30) Priorität: **27.11.90 DE 4037687**

(43) Veröffentlichungstag der Anmeldung:
**01.07.92 Patentblatt 92/27**

(84) Benannte Vertragsstaaten:
**AT BE CH DE ES FR GB IT LI NL SE**

(71) Anmelder: **Standard Elektrik Lorenz
Aktiengesellschaft
Lorenzstrasse 10
W-7000 Stuttgart 40(DE)**

(72) Erfinder: **Ohnesorge, Dieter
Tulpenstrasse 2
W-7252 Weil der Stadt 2(DE)**

(74) Vertreter: **Pechhold, Eberhard, Dipl.-Phys. et al
Standard Elektrik Lorenz AG Patent- und
Lizenzwesen Postfach 30 09 29
W-7000 Stuttgart 30(DE)**

(54) Einrichtung zur Prüfung von Baugruppen in digitalen elektronischen Systemen.

(57) Es wird eine Einrichtung zur Prüfung von Baugruppen (BG1, ..., BGn) in digitalen elektronischen Systemen angegeben, die eine Prüfung auf Systemebene gemäß der IEEE-Norm 1149.1 ohne feste Vorgabe von Anzahl und Position der zu prüfenden Baugruppen erlaubt. Auf jeder Baugruppe sind die für den Testzugriff vorhandenen Steuerschaltungen (STS) als Schnittstelle ausgebildet, welche aus zwei Steuerwerken besteht, von denen eines dem System-Abtastbus (SAB), das andere dem Baugruppen-Abtastbus (BAB) zugeordnet ist. Die Steuerwerke können die aktive Steuerfunktion gegenseitig tauschen. Es wird damit möglich, über den System-Abtastbus ein Steuerwerk einer Baugruppe anzusprechen, ohne den mit dem passivgeschalteten anderen Steuerwerk verbundenen Baugruppen-Abtastbus (BAB) zu beeinflussen. Diese Möglichkeit wird dazu genutzt, Baugruppen zunächst einzeln über ihre Steckplatzadresse auszuwählen und erst danach in einer Prüfoperation zu prüfen. Bei Entnahme oder Positionsveränderungen von Baugruppen brauchen weder die Verkabelung des System-Abtastbusses (SAB) noch die Prüfsoftware geändert zu werden.

FIG.1

Die Erfidung betrifft eine Einrichtung gemäß dem Oberbegriff des Patentanspruchs 1.

Eine solche Einrichtung ist z.B. im IEEE Standard 1149.1-1990 beschrieben. Sie dient dazu, integrierte Schaltkreise, Baugruppen und schließlich ganze Baueinheiten digitaler elektronischer Systeme auf Fehler, die innerhalb der verwendeten integrierten Schaltkreise, im Bereich der Verbindungen der Schaltkreise auf den Leiterplatten und in der Gestellverdrahtung auftreten, zu prüfen.

Es wird hier das Prinzip der Grenzabtastung (Boundary-Scan) angewandt. Hierbei sind alle Anschlüsse jedes integrierten Schaltkreises über im Bauelement integrierte Grenzabtastzellen mit der internen Schaltung des integrierten Schaltkreises verbunden. Die Grenzabtastzellen werden von einer mitintegrierten Steuerschaltung gesteuert und sind zusätzlich als Schieberegister zusammengeschaltet. Sie erlauben es einerseits, seriell in die Grenzabtastzellen eingegebene Testdaten parallel in Eingänge des integrierten Schaltkreises einzugeben, andererseits, an parallelen Ausgängen des Schaltkreises anstehende, abzutastende Daten seriell auszulesen.

Zum Test ganzer Baugruppen werden die seriellen Ein- und Ausgänge der Bauelement-Schieberegister in Reihe geschaltet, so daß sämtliche integrierten Schaltkreise einer Baugruppe samt ihren Verbindungen untereinander über einen einzigen seriellen Bus geprüft werden können.

Um die Zeiten der Prüfoperationen abzukürzen, können auch mehrere serielle Busse, die jeweils den Zugriff zu unterschiedlichen Gruppen von integrierten Schaltkreisen ermöglichen, vorgesehen sein. Eine unnötige Abfrage der Grenzabtastzellen von integrierten Schaltkreisen, die nicht geprüft zu werden brauchen, wird dadurch vermieden, daß Bypass-Register vorgesehen sind, die über die Steuerschaltungen der integrierten Schaltkreise gesetzt werden und die Schieberegister der nicht zu prüfenden Schaltkreise überbrücken.

Für die nächste Hierarchiestufe, das Prüfen ganzer Baueinheiten mit vielen Baugruppen, ist eine serielle Struktur eines System-Abtastbusses ungeeignet, da hierfür die Anzahl der bestückten oder bestückbaren Baugruppenplätze und die Positionen der Baugruppen fest vorgegeben sein müßte und bei Änderung der Anzahl oder der Position von Baugruppen die Verkabelung des Abtastbusses und die für die Baugruppen erzeugten Prüfdaten der geänderten Reihenfolge angepaßt werden müßten. Eine parallele Anordnung von Abtastbussen wäre ebenfalls nachteilig, da die Vervielfachung der Signalleitungen für den Maximalausbau des Systems ausgelegt sein müßte, und somit auf der Steckerseite zu viele Signale ungenutzt bereitgestellt werden müßten.

Es ist deshalb Aufgabe der Erfindung eine Einrichtung der vorstehend beschriebenen Art so zu verbessern, daß eine Prüfung von Baugruppen in Baueinheiten auch dann entsprechend der eingangs genannten Norm möglich ist, wenn Baugruppen in einer Baueinheit fehlen oder an wechselweise unterschiedlichen Steckplätzen gesteckt werden.

Eine Einrichtung, die die Aufgabe der Erfindung löst, ist im Patentanspruch 1 angegeben.

Durch die Ausgestaltung der weiteren Steuerschaltung als steuerbare Schnittstelle, deren einer Teil dem System-Abtastbus, deren anderer Teil aber dem seriellen Abtastbus der Baugruppe zugeordnet ist, wird es möglich, Baugruppen in einem ersten Schritt mit Hilfe einer durch den benutzten Steckplatz festgelegten Baugruppenadresse auszuwählen und in einem zweiten Schritt, ohne eine Beeinflussung anderer Baugruppen, zu prüfen.

Die Auswahl sowie die Prüfung erfolgen dabei mit derselben Prüfeinrichtung wie sie die eingangs genannte IEEE-Norm vorsieht.

Weiterbildungen der Einrichtung nach der Erfindung beschreiben die Patentansprüche 2 und 3. Patentanspruch 2 betrifft eine Ausgestaltung der steuerbaren Schnittstelle. Patentanspruch 3 enthält eine Maßnahme, mit deren Hilfe eine Mehrfachadressierung von Baugruppen durchgeführt werden kann.

Anhand von 3 Figuren soll nun ein Ausführungsbeispiel der Einrichtung nach der Erfindung beschrieben werden.

Fig. 1     zeigt Baugruppen, die über einen System-Abtastbus mit einem Prüfrechner verbunden sind,

Fig. 2     zeigt das Prinzipschaltbild einer Steuerschaltung auf einer Baugruppe,

Fig. 3     zeigt ein Flußdiagramm für die Funktion einer Steuerschaltung.

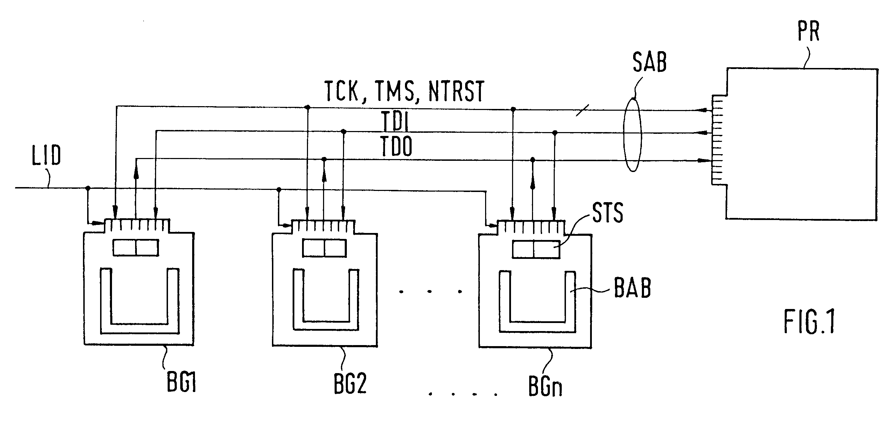

In Fig. 1 sind eine Anzahl Baugrupen BG1, ... BGn wiedergegeben, die über einen seriellen System-Abtastbus SAB mit einem Prüfrechner PR verbunden sind. Der System-Abtastbus, an den alle Baugruppen parallel angeschlossen sind, weist zwei Steuerleitungen TMS, NTRST, eine Taktleitung TCK, eine Dateneingangsleitung TDI und eine Datenausgangsleitung TDO auf. Der System-Abtastbus ist auf den Baugruppen mit einer Steuerschaltung STS verbunden. Über eine Identifikationszuleitung LID besteht die Möglichkeit, jeder Baugruppe eine individuelle Baugruppenadresse zuzuordnen. Zur Abfrage werden die einzelnen Baugruppen mit Hilfe ihrer Baugruppenadresse vom Prüfrechner ausgewählt. Die Steuerschaltung stellt anschließend die Verbindung zwischen dem System-Abtastbus und dem jeweiligen seriellen Baugruppen-Abtastbus her, so daß der Prüfrechner den Prüfvorgang vornehmen kann.

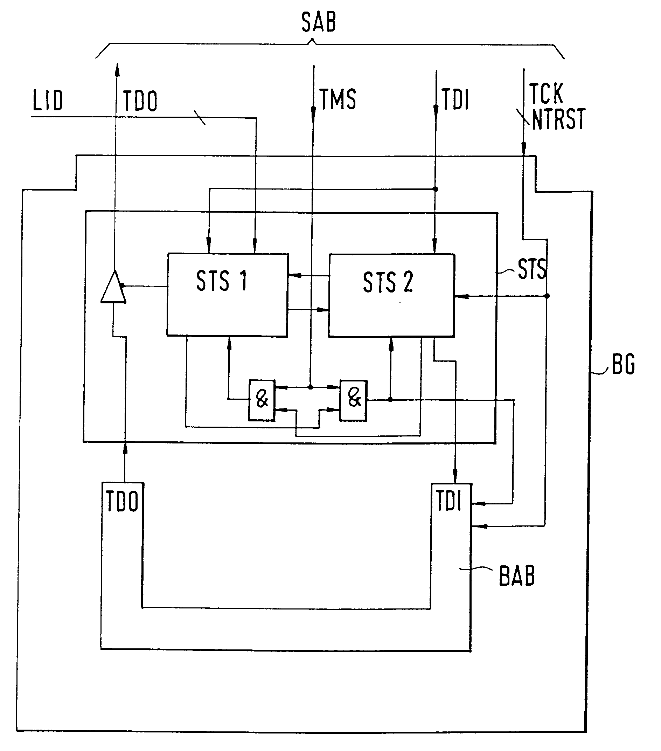

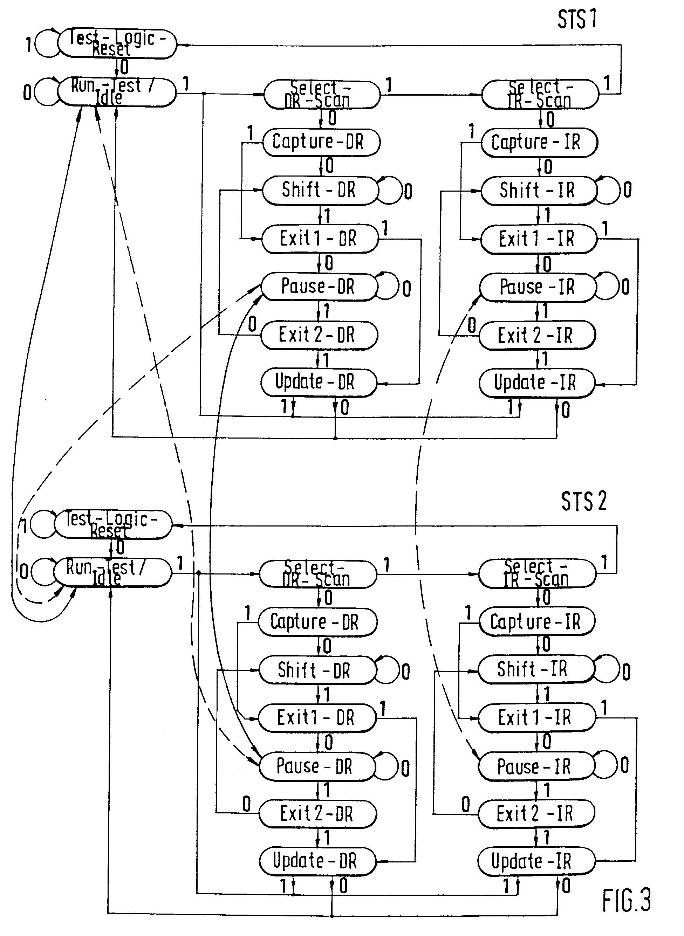

In Fig. 2 ist eine Baugruppe BG mit einem Baugruppen-Abtastbus BAB und einer Steuerschaltung STS dargestellt. Die Steuerschaltung ist in ein dem System-Abtastbus SAB zugeordnetes Steuerwerk STS1 und ein dem Baugruppen-Abtastbus zugeordnetes Steuerwerk STS2 aufgeteilt. Beide Steuerwerke bekommen den Takt TCK und die Steuerleitung TMS des System-Abtastbusses zugeführt. Über Und-Glieder können sich beide Steuerwerke gegenseitig aktiv oder passiv schalten. Die Baugruppenadresse ist über die Zuleitung LID nur dem dem System-Abtastbus zugeordneten Steuerwerk STS1 zugeführt, da nur dieses bei der Auswahl der Baugruppe mitwirkt. Der serielle Eingang des Baugruppen-Abtastbusses ist dagegen nur mit dem dem Baugruppen-Abtastbus zugordneten Steuerwerk STS2 verbunden. Die Funktion der Steuerschaltung wird im folgenden anhand des Flußdiagramms in Fig. 3 beschrieben.

Beide Steuerwerke STS1, STS2 können abwechselnd oder zeitweise gleichzeitig in Abhängigkeit bestimmter Kommandos aktiviert werden. Nach einer Initialisierungphase befinden sich beide Steuerwerke im Status "Test-Logic-Reset", wobei das Steuerwerk STS1 die Kontrolle über das Steuerwerk STS2 hat, d.h. durch Beeinflussung einer internen TMS-Leitung kann ein Statuswechsel des Steuerwerks STS2 unterbunden werden. Diese intern kontrollierte TMS-Leitung wird den auf der Baugruppe vorhandenen Bauelementen innerhalb des Baugruppen-Abtastbusses BAB als deren TMS-Leitung zur Verfügung gestellt.

Ebenso kann das Steuerwerk STS2 die interne TMS-Leitung des Steuerwerks STS1 beeinflussen.

Die gegenseitige Umschaltung des jeweils aktiven Steuerwerks kann ausschließlich in den Stati "Run-Test/Idle" oder "Pause-DR" erfolgen. Prinzipiell ist eine Umschaltung auch im Status "Pause-IR" möglich.

Der Wechsel der aktiven Funktion erfolgt dabei in der Regel von einem Status des einen Steuerwerks in den gleichen Status des anderen Steuerwerks z.B. vom Status "Pause-DR" des Steuerwerks STS2 entsprechend dem durchgezogenen Doppelpfeil in den Status "Pause-DR" des Steuerwerkes STS1 oder umgekehrt. Es können aber auch Übergänge zwischen unterschiedlichen Stati der beiden Steuerwerke, z.B. entsprechend der punktierten Doppelpfeile von "Pause-DR" des einen zum Status "Run-Test/Idle" des anderen Steuerwerks vorgesehen wurden. Ein schematischer Ablauf sieht wie folgt aus:

1. Initialisierung (z.B. durch die Steuerleitung NTRST = 0), beide Steuerwerke sind in "Test-Logic-Reset",

2. TMS = 0, beide Steuerwerke in "Run-Test/Idle". Da das Steuerwerk STS1 nach der Initialisierung die Kontrolle hat, wird die interne TMS-Leitung des Steuerwerks STS2 auf 0 festgehalten. Damit bleibt dieses Steuerwerk im Zustand "Run-Test/Idle" (unabhängig vom Zustand der Leitungen TDI und TMS).

3. Durch Steuerung über die Leitungen TMS, TDI wird nun eine Einleseoperation durchgeführt, die eine bestimmte Baugruppe auswählt. Hierzu wird das nach der eingangs genannten Norm definierte Kommando "Bypass" verwendet, das nun alle am System-Abtastbus aktiven Steuerwerke veranlaßt, nach Aktivierung der Instruktion (Update-IR) ein Identifikationsregister (IEEE: Optional User Data Register) zum Einlesen bereitzustellen. Das Identifikationsregister besteht aus einem Kontrollbit, das, wenn es gesetzt wird, eine mehrfache Selektion von Baugruppen zulassen kann, ohne bereits selektierte Baugruppen zu deselektieren und aus einer zur eindeutigen Kennung der Baugruppe notwendigen Anzahl von Identifikationsbits. Das Identifikationskennzeichen der Baugruppe wird dem Steuerwerk STS1 in geeigneter Weise zur Verfügung gestellt.

Die in das Identifikationregister einzugebenden seriellen Daten werden über die Leitung TDI eingegeben und im "Update-DR"-Status ausgewertet. Stimmt die eingeschobene Kennummer mit der Kennung der Baugruppe überein, wird diese selektiert (bzw. deselektiert, falls sie selektiert war und das Kontrollbit 0 gesetzt war). Mit der Selektion kann auch eine Aktivierung des Datenausganges TD0 verbunden sein; diese kann aber auch zu einem späteren Zeitpunkt erfolgen, wenn dies für die Funktion des Kommandos erforderlich ist, damit bei Mehrfachselektion sichergestellt ist, daß es zu keinem Konflikt auf der Datenausgangsleitung TD0 kommt.

4. Das Steuerwerk STS1 bleibt aktiv, bis es in den Status "Run-Test/Idle" gebracht wird. Mit dem Übergang in diesen Status gibt es die aktive Steuerfunktion an das Steuerwerk STS2 ab; dessen interne TMS-Leitung wird freigegeben, die des Steuerwerks STS1 gesperrt.

Damit kann nun vom System-Abtastbus direkt mit dem baugruppeninternen Abtastbus BAB gearbeitet werden. Ist die Prüfung beendet, wird die aktive Steuerfunktion über den Status "Run-Test/Idle" wieder an das Steuerwerk STS1 zurückgegeben.

Bestimmte Kommandos (z.B. SAMPE, EXTEST) veranlassen das Steuerwerk STS2 zusammen mit dem MSB-Kontrollbit, die Sperre des Steuerwerks STS1 aufzuheben, ohne daß das Steuerwerk STS2 gesperrt wird. Somit können beide Steuerwerke den Status "Pause-DR" wechseln, in dem dann die aktive Steuerfunktion wieder jeweils abgegeben werden kann. Dies ist notwendig, um in mehreren Baugruppen zur gleichen Zeit (mit der gleichen Taktflanke TCK) in den Status "Capture-DR" zu gelangen und anschließend vom Status "Pause-DR" aus die jeweiligen Baugruppen-Abtastbusse nacheinander auslesen zu können.

5. Zum Abschluß der Prüfung wird die aktive Steuerfunktion wieder auf das Steuerwerk STS1 übertragen; dies kann auch dadurch bewirkt werden, daß das Steuerwerk STS2 in den Status "Test-Logic-Reset" gebracht wird.

6. Das Steuerwerk STS1 wird initialisiert, indem es ebenfalls in den Zustand "Test-Logic-Reset" gebracht wird.

Die Identifikationskennung kann vom Steuerwerk STS1 über ein spezielles Kommando ausgelesen werden; dies ist beim Steuerwerk STS1 zu spezifizieren.

## Patentansprüche

1. Einrichtung zur Prüfung von Baugruppen in digitalen elektronischen Systemen, bei denen auf den Baugruppen angeordnete integrierte Schaltkreise in ihren Anschlußleitungen von jeweils einer gemeinsamen Steuerschaltung gesteuerte Grenzabtastzellen enthalten, welche untereinander in der Art eines Schieberegisters verbunden sind, dessen serieller Eingang und Ausgang jeweils zusammen mit mindestens einer Takt- und einer Steuerleitung für die Steuerschaltung einen seriellen Abtastbus (Scanpfad) bilden und bei denen die Abtastbusse mehrerer oder aller integrierten Schaltkreise einer Baugruppe zu mindestens einem seriellen Baugruppen-Abtastbus zusammengeschaltet sind, über den von einem Prüfrechner Prüfdaten in die integrierten Schaltkreise eingegeben und Abtastdaten aus den integrierten Schaltkreisen ausgelesen werden, wobei zur Steuerung des Baugruppen-Abtastbusses eine weitere, der Baugruppe zugeordnete Steuerschaltung vorgesehen ist,

   **dadurch gekennzeichnet,** daß die weitere Steuerschaltung (STS) als Schnittstelle zwischen dem Baugruppen-Abtastbus (BAB) und einem übergeordneten System-Abtastbus (SAB) ausgebildet ist und daß, abhängig von der Übereinstimmung einer durch die aktuelle Position der Baugruppe (BG1, ..., BGn) im System vorgegebenen Baugruppenadresse mit einer Prüfadresse, welche über den System-Abtastbus bei von diesem abgetrennten Baugruppen-Abtastbus an die Steuerschaltung ausgegeben wird, eine Anschaltung des Abtastbusses der jeweils zu prüfenden Baugruppe an den System-Abtastbus erfolgt.

2. Einrichtung nach Anspruch 1, dadurch gekennzeichnet, daß die weitere Steuerschaltung (STS) aus zwei im wesentlichen gleichen Steuerwerken (STS1, STS2) besteht, von denen eines dem Baugruppen-Abtastbus (BAB), das andere dem System-Abtastbus (SAB) zugeordnet ist, daß jedes Steuerwerk in der Lage ist, das jeweils andere Steuerwerk über dessen Steuerleitung passiv zu schalten, daß das dem System-Abtastbus (SAB) zugeordnete Steuerwerk (STS1) ein Identifikationsregister enthält, in welches in einer einer Prüfoperation vorausgehenden Einleseoperation, während der die dem Baugruppen-Abtastbus zugeordnete Teilschaltung (STS2) passiv ist, die Adresse einer zu prüfenden Baugruppe eingelesen wird und daß bei Übereinstimmung der eingelesenen Adresse mit der vorgegebenen Baugruppenadresse das dem Baugruppen-Abtastbus zugeordnete Steuerwerk (STS2) zur Durchführung einer Prüfoperation aktiv geschaltet wird.

3. Einrichtung nach Anspruch 2, dadurch gekennzeichnet, daß im Identifikationsregister ein Kontrollbit gesetzt werden kann, welches ein Überschreiben des Identifikationsregisters verhindert und damit eine Mehrfachadressierung von Baugruppen ermöglicht.

FIG.1

FIG.3

Europäisches Patentamt

**EUROPÄISCHER RECHERCHENBERICHT**

Nummer der Anmeldung

EP    91 11 9486

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 701 921 (POWELL ET AL.)<br>* Spalte 2, Zeile 53 - Zeile 68 *<br>* Spalte 3, Zeile 1 - Zeile 14 *<br>* Spalte 5, Zeile 26 - Zeile 35 *<br>* Spalte 6, Zeile 51 - Zeile 61 *<br>* Spalte 9, Zeile 19 - Zeile 40 *<br>--- | 1,2 | G06F11/26 |
| X | US-A-4 947 357 (STEWART ET AL.)<br>* Spalte 3, Zeile 39 - Zeile 63 *<br>* Spalte 8, Zeile 47 - Zeile 62 *<br>* Spalte 6, Zeile 8 - Zeile 18 *<br>* Spalte 9, Zeile 1 - Zeile 14 *<br>* Spalte 9, Zeile 25 - Zeile 41 *<br>--- | 1 | |
| A | US-A-4 038 648 (CHESLEY)<br>* Spalte 5, Zeile 23 - Zeile 58 *<br>--- | 2,3 | |
| A | WESCON 88/CONFERENCE RECORD.<br>Bd. 32, Nr. 13, November 1988, NORTH HOLLYWOOD US<br>Seiten 1 - 5;<br>LEE WHETSEL: 'A proposed standard test bus and boundary scan architecture'<br>* Seite 5, linke Spalte, Zeile 12 - Zeile 23 *<br>--- | 2,3 | RECHERCHIERTE SACHGEBIETE (Int. Cl.5)<br><br>G06F |
| A | IBM TECHNICAL DISCLOSURE BULLETIN.<br>Bd. 32, Nr. 4A, September 1989, NEW YORK US<br>Seiten 262 - 264; 'Using a portion of the boundary register as the identification register'<br>* das ganze Dokument *<br><br>----- | 2,3 | |

Der vorliegende Recherchenbericht wurde für alle Patentansprüche erstellt

| Recherchenort | Abschlußdatum der Recherche | Prüfer |
|---|---|---|
| BERLIN | 18 MAERZ 1992 | DURAND J. |

EPO FORM 1503 03.82 (P0403)